# NEUE EUROPÄISCHE PATENTSCHRIFT

(11) **EP 0 634 087 B2**
(45) Veröffentlichungstag und Bekanntmachung des Hinweises auf die Entscheidung über den Einspruch: **15.04.2009**
(45) Hinweis auf die Patenterteilung: 09.07.1997
(21) Anmeldenummer: 93907843.2
(22) Anmeldetag: 29.03.1993
(51) Int. Cl.: H05K 9/00, H02M 3/28, H05B 41/292, H02M 5/00

(54) **ELEKTRONISCHES VORSCHALTGERÄT FÜR EINE GASENTLADUNGSLAMPE**
ELECTRONIC BALLAST FOR A GAS DISCHARGE LAMP
BALLAST ELECTRONIQUE POUR UNE LAMPE LUMINESCENTE A GAZ

(30) Priorität: 31.03.1992 DE 4210624
(43) Veröffentlichungstag der Anmeldung: 18.01.1995
(73) Patentinhaber: TridonicAtco GmbH & Co. KG, 6851 Dornbirn (AT)
(72) Erfinder: MARINELLI, Thomas, A-6922 Wolfurt (AT); LUGER, Siegfried, A-6850 Dornbirn (AT); TRÖSTL, Alfred, A-6850 Dornbirn (AT)
(74) Vertreter: Schmidt-Evers, Jürgen
(86) Internationale Anmeldenummer: PCT/EP1993/000753
(87) Internationale Veröffentlichungsnummer: WO 1993/020677

(56) Entgegenhaltungen:
- EP-A1- 0 267 129
- EP-A1- 0 338 109
- EP-A2- 0 444 428
- DE-G- 911 013 3.1
- US-A- 4 943 886
- COMPUTER TECHNOLOGY REVIEW. Bd. 4, Nr. 3, 1984, LOS ANGELES US Seiten 287 - 300 WARREN H. LEWIS 'proper grounding helps protect electronics from effects of noise'
- 'Elektronik 9/27.04.1990', Artikel MATTHIAS JUNG: 'Durchflusswandler-Schaltnetzteil für 200 Watt', Seite 158-166
- SIEMENS AG 1982, Artikel WALTER HIRSCHMANN: 'Elektronikschaltungen', Seite 147-148
- 'Electronic Industry, 1-1987', Artikel WILFRIED BLASNER: 'Sperrwandler-Schaltnetzteil für Monitor- und TV-Anwendungen', Seite 28

## Beschreibung

Die Erfindung betrifft ein elektronisches Vorschaltgerät für eine Gasentladungslampe gemäß Oberbegriff des Anspruches 1.

Ein Vorschaltgerät der hier betrachteten Art ist beispielsweise nach der EP 0 338 109 A1 und der DE 39 25 899 A1 bekannt. Dieses Vorschaltsgerät erlaubt ein Dimmen der Lampe durch Veränderung der Frequenz des Wechselrichters.

Bei Lampen, die mit einem Vorschaltgerät der hier betrachteten Art betrieben werden, wurde bisher ein Flackern mit Netzfrequenz festgestellt, das sich insbesondere im stark herabgedimmten Zustand störend auswirkt.

Der Erfindung liegt die Aufgabe zugrunde, die vorstehend beschriebenen Störungen zu vermeiden.

Bevor die Lösungen für die Aufgabe angegeben werden, soll nachfolgend zunächst dargelegt werden, wodurch die Störungen verursacht werden: Ein Ausgangsanschluß des Brückengleichrichters liegt ebenso wie ein Eingangsanschluß und ein Ausgangsanschluß des Wechselrichters auf einem schaltungsinternen Bezugspotential, das nachfolgend als "Massepotential" bezeichnet wird. Die Eingangsanschlüsse des Brückengleichrichters sind mit dem Phasenanschluß und dem Null-Leiteranschluß des Netzes verbunden, und keiner der beiden Eingangsanschlüsse liegt auf dem schaltungsinternen Massepotential. Dementsprechend schwankt das schaltungsinterne Massepotential von Halbwelle zur Halbwelle der Netzspannung gegenüber Schutzerde bzw. dem normalerweise mit Schutzerde verbundenen Metallgehäuse des Gerätes in Form von Rechteckimpulsen mit Netzfrequenz und einer Amplitude, die etwa gleich dem Spitzenwert der Netzwechselspannung ist. Die relativ steilen Flanken dieser Rechteckimpulse ergeben mit den Schaltkapazitäten der Lampen-Zuleitungen jeweils im Null-Durchgang der Netzwechselspannung Nadelimpulse, die den Lampenstrom kurzzeitig erhöhen, bzw. erniedrigen. Diese nadelimpulsförmigen Änderungen des Lampenstromes werden bei aufgedimmter Lampe weniger stark wahrgenommen als bei herabgedimmter Lampe.

Die erwähnten nadelimpulsartigen Störungen des Lampenstromes wirken sich auch bei der Regelung der Lampenhelligkeit störend aus. Die Lampenhelligkeit wird über die Frequenz des Wechselrichters verändert. Der Istwert des Lampenstromes wird als Spannungsabfall an einem vom Lampenstrom durchflossenen Widerstand gemessen und dem Regelungsteil für den Wechselrichter zugeführt.

Zur Lösung der oben angegebenen Aufgabenstellung werden vier Möglichkeiten angegeben.

Die erste Lösung besteht darin, daß der schaltungsinterne Bezugspotential-Anschluß, nachfolgend "Masse" genannt, wechselstrommäßig mit der Schutzerde des Wechselstromnetzes oder - falls das Gerätegehäuse mit Schutzerde verbunden ist - wechselstrommäßig mit dem Gerätegehäuse verbunden ist. Die wechselstrommäßige Verbindung kann durch einen Kondensator realisiert werden, der bei den gemäß vorheriger Anlayse die Nadelimpulse bestimmende Frequenzanteilen eine niedrige Impedanz hat.

Die zweite Lösung besteht nun darin, daß die schaltungsinterne Masse mit dem Phasenanschluß und/oder dem Null-Leiteranschluß oder mit einem und/oder beiden Eingangsanschlüssen des Brückengleichrichters wechselstrommäßig verbunden ist. Die Realisierung der wechselstrommäßigen Verbindung kann auch hier wieder durch einen Kondensator erfolgen, der bei den die Nadelimpulse bestimmenden Frequenzanteilen eine niedrige Impedanz hat.

Die dritte Lösung besteht darin, daß der andere Ausgangsanschluß des Brückengleichrichters durch einen Kondensator wechselstrommäßig mit der Schutzerde des Wechselstromnetzes verbunden ist.

Die vierte Lösungsmöglichkeit besteht darin, daß die vom Vorschaltgerät zur Lampe führenden Leitungen abgeschirmt sind und die Abschirmungen mit der schaltungsinternen Masse verbunden sind.

Die erste und die zweite Lösung haben gegenüber der dritten Lösung den Vorzug, daß sie billiger und daher für eine Produktion des Vorschaltgerätes in großen Stückzahlen besser geeignet sind.

Ein Ausführungsbeispiel der Erfindung wird nachfolgend anhand der Zeichnungen beschrieben.

Es zeigen:
Figur 1 die Schaltung des teilweise schematisierten Vorschaltgerätes mit angeschlossener Lampe;
Figur 2 ein Ersatzschaltbild zur Erklärung der Störimpulse;
Figuren 3 bis 7 den zeitlichen Verlauf von Spannungen an verschiedenen Stellen der Schaltung nach Figur 1, wobei die Darstellung nicht maßstäblich ist.
Figur 8 die Schaltung wie in Figgur 1, wobei lediglich ein Kondensator versetzt worden ist.

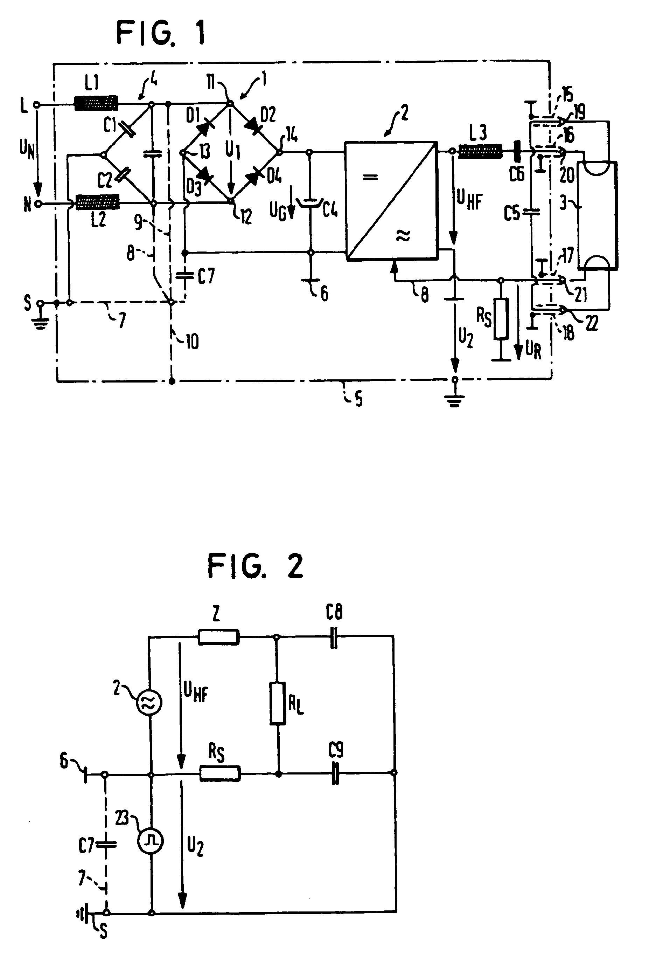

Das Vorschaltgerät gemäß Figur 1 befindet sich in einem Metallgehäuse 5. Es ist mit drei Eingangsanschlüssen L,N und S versehen. Die Eingangsanschlüsse L und N werden an die Wechselspannungsanschlüsse des Wechselstromnetzes angeschlossen, wobei es gleichgültig ist, ob der Eingangsanschluß L mit dem Phasenanschluß und der Eingangsanschluß N mit dem Null-Leiteranschluß verbunden sind oder umgekehrt. Auf jeden Fall muß der Eingangsanschluß S mit den Schutzerdeanschluß des Wechselstromnetzes verbunden werden.

Die an den Eingangsanschlüssen L und N anliegenden Netzwechselspannung U_{N} wird über die beiden Drosseln L1, L2 dem Eingang eines Brückengleichrichters 1 zugeführt,dessen Eingangsanschlüsse mit 11 und 12 bezeichnet sind. Mit den Eingangsanschlüssen 11 und 12 des Brückengleichrichters 1 ist ein Oberwellenfilter 4 verbunden, das aus den Drosseln L1, L2 und dem Kondensator C3 besteht. Der Kondensator C3 ist direkt zu dem Eingang des Brückengleichrichters 1 parallel geschaltet. Die Funkentstörkondensatoren C1 und C2 sind in Reihe geschaltet und - als Reihenschaltung - ebenfalls zum Eingang des Brückengleichrichtets 1 parallel geschaltet. Der Verbindungspunkt zwischen den Kondensatoren C1, C2 ist mit dem Schutzerdeanschluß S verbunden.

Der Brückengleichrichter 1 besteht aus vier Dioden D1, D2, D3 und D4, die in üblicher Weise gepolt sind.

Die Ausgangsanschlüsse des Brückengleichrichters 1 sind mit 13 und 14 bezeichnet. Zwischen den beiden Ausgangsanschlüssen 13 und 14 liegt ein Glättungskondensator C4. Der Ausgangsanschluß 13 des Brückengleichrichters 1 ist mit einer schaltungsinternen Masse 6 verbunden.

Der Ausgang des Brückengleichrichters 1 ist mit dem Eingang eines Wechselrichters 2 verbunden, dessen Frequenz wie üblich zum Vorwärmen und Zünden der Lampe veränderbar und regelbar ist. Gedimmt werden kann die Lampen durch Frequenz und/oder Tastverhältnisvariation. Der Regelungsteil ist hier der Einfachheit halber nicht gesondert dargestellt. Ein Eingangsanschluß und ein Ausgangsanschluß des Wechselrichters 2 ist jeweils mit der Masse 6 verbunden. Der Ausgang des Wechselrichters 2 gibt eine Hochfrequenzspannung U_{HF} ab. Diese wird über eine Induktivität L3 und einen Trennkondensator C6 einem Ausgangsanschluß 20 des Vorschaltgerätes zugeführt. Ein zweiter Ausgangsanschluß 21 ist über einen Shunt-Widerstand R_{S} mit Masse 6 verbunden. Ein dritter Ausgangsanschluß 19 und ein vierter Ausgangsanschluß 22 sind durch einen Parallelkondensator C5 miteinander verbunden. Die Heizungsanschlüsse der einen Lampenelektrode liegen an den Ausgangsanschlüssen 19 und 20. Die Heizungsanschlüsse der anderen Lampenelektrode liegen an den Ausgangsanschlüssen 21 und 22.

Die über dem Shunt-Widerstand R_{S} abfallende Spannung, die dem Lampenstrom proportional ist, wird über eine Leitung 8 (dem nicht dargestellten) Regelungsteil des Wechselrichters 2 zugeführt.

Die Wirkung der Schaltung des Vorschaltgerätes gemäß Figur 1 zum Betrieb der Lampe 3 ist an sich bekannt. Die Beschreibung kann daher entsprechend kurz gehalten werden. Mit dem Wechselrichter 2 ist es möglich, eine Hochfrequenzspannung U_{HF} zu erzeugen, die etwa gleich der Resonanzfrequenz des von der Induktivität L3 und dem Parallelkondensator C5 gebildeten Serienresonanzkreises ist. Bei der dieser Resonanzfrequenz tritt an dem Parallelkondensator C5 eine Spannungsüberhöhung auf, die zur Zündung der Lampe 3 führt. Nachdem die Lampe 3 gezündet hat, können der Lampenstrom und die Lampenspannung und damit auch die Lampenhelligkeit durch Veränderung der Frequenz der Hochfrequenzspannung U_{HF} geregelt werden. Ferner kann die Lampe 3 durch Veränderung der Frequenz und/oder des Tastverhältnisses gedimmt, d.h. hell- oder dunkelgesteuert werden.

Wie eingangs beschrieben, ist bei mit Vorschaltgeräten der in Figur 1 gezeigten Art betriebenen Lampen ein Flackern mit Netzfrequenz zu beobachten, das insbesondere im herabgedimmten Zustand störend ist. Die Ursache für dieses Flackern soll nachfolgend erläutert werden.

Es sei angenommen, daß der Eingangsanschluß L mit dem Phasenanschluß des Netzes verbunden sei, und daß der Eingangsanschluß N mit dem Null-Leiteranschluß des Netzes verbunden sei. Bekanntlich liegt der Null-Leiteranschluß des Wechselstromnetzes von Kraftwerksbetreiber her auf dem Potential von Schutzerde, d.h. im Kraftwerk sind Schutzerde und Null-Leiter miteinander verbunden. Aus Sicherheitsgründen werden der Null-Leiter und die Schutzerde dann separat zum Verbraucher, d.h. an die Steckdose geführt.

Wenn am Eingangsanschluß L eine positive Netzhalbwelle anliegt, so sind die Dioden D2 und D3 des Brückengleichrichters 1 leitend. An der Diode D3 fällt die Dioden-Durchschaltspannung von 0,7 V ab. Das bedeutet, daß der Schaltungspunkt 13 und damit die mit dieser verbundene Masse 6 eine Spannung haben, die um +0,7V über derjenigen an dem Schaltungspunkt 12 bzw. dem Eingangsanschluß N bzw. Schutzerde S liegen.

Wenn an dem Eingangsanschluß L die negative Netzspannungshalbwelle anliegt, so sind die Dioden D1 und D4 des Brückengleichrichters 1 leitend. Das bedeutet, daß über der Diode D1 die Dioden-Durchschaltspannung von 0,7V abfällt. Zum Zeitpunkt der Netzspitzenspannung von etwa -320V haben dann der Schaltungspunkt 13 und die Masse 6 eine um +0,7V höhere Spannung als der Schaltungspunkt 11 und der Eingangsanschluß L, d.h. die Masse 6 liegt in diesem Fall auf dem Potential von - 319,3V.

Die Spannung der Masse 6 schwankt also gegenüber Schutzerde S bzw. dem Potential des Gerätegehäuses 5 von Halbwelle zu Halbwelle zwischen +0,7V und -319,3V, also um die Spannung U₂ = 320V.

Da auch der eine Ausgangsanschluß des Wechselrichters 2 mit der Masse 6 verbunden ist, ist in Figur 1 diese von Halbwelle zu Halbwelle schwankende Spannung U₂ zwischen dem Ausgangsanschluß des Wechselrichters 2 und dem Gehäuse 5 dargestellt.

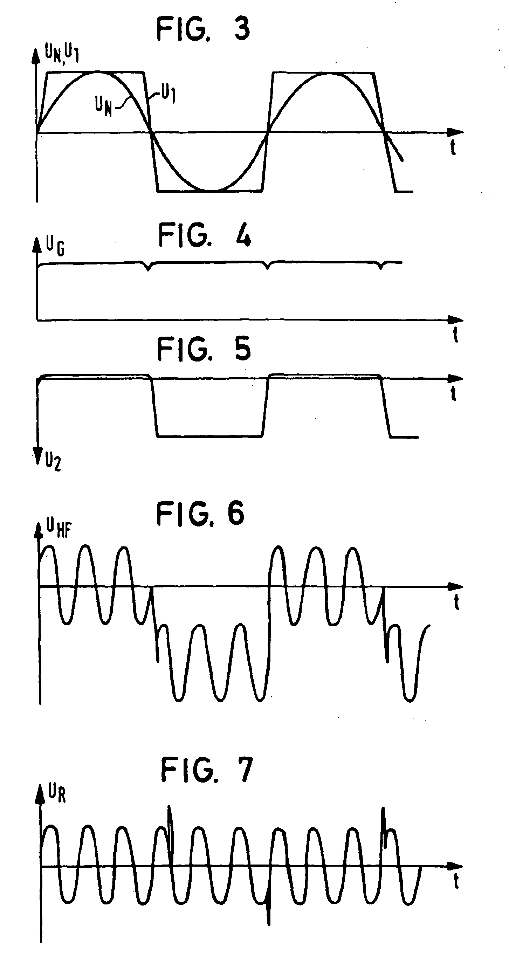

Figur 3 zeigt den zeitlichen Verlauf der sinusförmigen Netzspannung U_{N} sowie den etwa rechteckförmigen Verlauf der über dem Eingang des Brückengleichrichters 1 abfallenden Spannung U₁. Der rechteckförmige Verlauf ergibt sich durch Zusammenwirken des Brückengleichrichters 1 mit dem Oberwellenfilter und dem Kondensator C4. U_{N} und U₁ können in Abhängigkeit von den Schaltelementen phasenverschoben sein.

Figur 4 zeigt den zeitlichen Verlauf der geglätteten Gleichspannung U_{G} am Ausgang des Brückengleichrichters 1.

Figur 5 zeigt den zeitlichen Verlauf der zwischen der Masse 6 und Schutzerde bzw. dem Gerätegehäuse auftretenden Spannung U₂. Die Spannung U₂ bildet das Basispotential für die von dem Wechselrichter 2 erzeugte Hochfrequenzspannung U_{HF}. Deren zeitlicher Verlauf ist in Figur 6 dargestellt.

Figur 7 zeigt die am Shunt-Widerstand R_{S} abfallende Spannung U_{R}, die dem Lampenstrom proportional ist. Man erkennt, daß die Spannung U_{R} an den Stellen, an denen die Netzwechselspannung U_{N} Null Durchgänge hat, Nadelimpulse auftreten. Diese Nadelimpulse bewirken das Flackern der Lampenhelligkeit sowie Störungen bei der Regelung des Wechselrichters 2.

Nachfolgend sollen nun die Lösungen zur Beseitigung der erwähnten Nadelimpulse diskutiert werden. Dazu sei das Ersatzschaltbild in Figur 2 betrachtet. Dieses zeigt den Wechselrichter 2, dessen einer Ausgangsanschluß mit der Masse 6 verbunden ist. Ferner liegt am Ausgang des Wechselrichters 2 eine Reihenschaltung aus Z,R_{L} und R_{S}. Z repräsentiert im wesentlichen die von der Induktivität L3 und dem Trennkondensator C6 gebildete Impedanz. R_{L} ist der Innenwiderstand der Lampe 3 mit parallel geschaltetem Kondensator C5. R_{S} ist der Shunt-Widerstand. Zwischen dem einen Anschluß des Wechselrichters 2 und der damit verbundenen Masse 6 und Schutzerde S bzw. dem mit Schutzerde verbundenen Gehäuse liegt eine Impulsquelle 23, die die Spannung U₂ erzeugt. Die beiden Anschlüsse der durch den Lampeninnenwiderstand R_{L} repräsentierten Lampe sind über Schaltkapazitäten C8 und C9 mit dem Gerätegehäuse bzw. Schutzerde S verbunden. Die Schaltkapazitäten C8 und C9 bilden mit R_{L} Differenzierglieder, die bewirken, daß die Rechteckspannung U₂ an den Flanken die Nadelimpulse an R_{L} erzeugt.

Eine erste Möglichkeit zur Beseitigung der Nadelimpulse besteht darin, die Masse 6 durch einen Kondensator C7 direkt mit dem Schutzerdeanschluß S oder dem mit dem Schutzerdeanschluß S verbundenen Gehäuse 5 zu verbinden. Die Verbindungen sind durch die gestrichelten Verbindungslinien 7 und 10 in Figur 1 angedeutet.

Eine zweite Möglichkeit besteht darin, die Masse 6 durch den Kondensator C7 mit einem der beiden Eingangsanschlüsse 11,12 des Brückengleichrichters 1 zu verbinden, wie dies durch die gestrichelten Verbindungslinien 8 und 9 angedeutet ist. Die zweite Möglichkeit ist allerdings der erstgenannten Möglichkeit vorzuziehen, da bei der erstgenannten Möglichkeit unerwünscht hohe Ableitströme fließen.

Die Wirkung der Lösungsmöglichkeit 1 und 2 besteht darin, daß durch den Kondensator C7 die scharfen Flanken der Rechteckspannung U₂ abgeschliffen werden, mit der Folge, daß die Amplitude der Differentation entstehenden Nadelimpulse bis zur Unwirksamkeit vermindert wird.

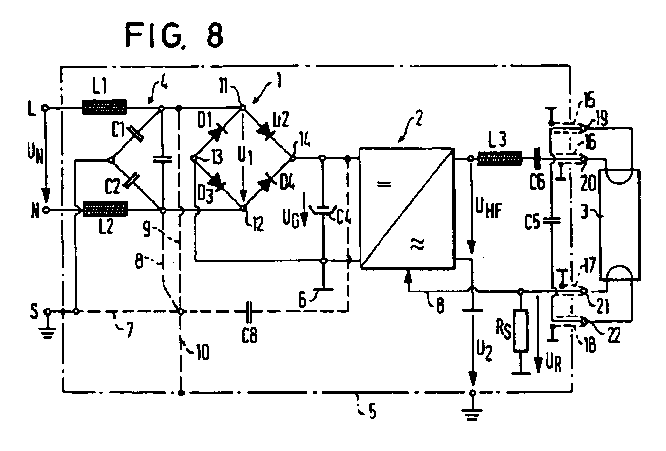

Eine dritte Möglichkeit besteht gemäß Figur 8 darin, den Kondensator C7 aus Figur 1 durch den Kondensator C8 zu ersetzen, der den anderen Ausgangsanschluß 14 des Brückengleichrichters 1 mit Schutzerde S verbindet. Da der Ausgangsanschluß 14 über den Kondensator C4 mit Masse 6 verbunden ist, stellt die dritte Möglichkeit an sich nur eine schaltungsmäßige Variante der ersten Möglichkeit dar.

Die vierte Möglichkeit besteht darin, daß die Lampenzuleitungen abgeschirmt geführt werden wobei die Abschirmungen mit Masse 6 verbunden werden. Die Abschirmungen sind durch die gestrichelten Linien 15,16, 17 und 18 in Figur 1 angedeutet. Die Wirkung dieser Maßnahme besteht darin, daß die Schaltkapazitäten C8 und C9 so stark vermindert werden, daß sie mit R_{L} praktisch kein wirksames Differenzierglied mehr bilden.

Es ist auch möglich, zwischen den Gleichrichter 1 und den Glättungskondensator C4 ein aktives Oberwellenfilter einzufügen, wie dies beispielsweise in den deutschen Patenten 28 01 391 und 33 10 774 beschrieben ist. Das passive Oberwellenfilter 4 mit den Schaltungselementen L₁, L₂, C1, C2 und C3 kann dann entfallen, soweit es nicht zur Funkentstörung benötigt wird. An der Schaltung des Kondensators C7 ändert sich bei Verwendung eines aktiven Oberwellenfilters nichts.

## Patentansprüche

1. Elektronisches Vorschaltgerät für eine Gasentladungslampe (3), bestehend aus einem an das Wechselspannungsnetz anzuschließenden Brückengleichrichter (1) und einem diesem nachgeschalteten Wechselrichter (2) zum Versorgen der Lampe mit einer Wechselspannung, wobei ein Ausgangsanschluß (14) des Brückengleichrichters (1) sowie ein Eingangs- und ein Ausgangsanschluß des Wechselrichters (2) mit einem schaltungsinternen Bezugspotential-Anschluß (6) verbunden sind,
**dadurch gekennzeichnet,**
**daß** der schaltungsinterne Bezugspotential-Anschluß (6) wechselstrommäßig mit der Schutzerde (S) des Wechselstromnetzes verbunden ist.

2. Elektronisches Vorschaltgerät für eine Gasentladungslampe (3), bestehend aus einem an das Wechselspannungsnetz anzuschließenden Brückengleichrichter (1) und einem diesem nachgeschalteten Wechselrichter (2) zum Versorgen der Lampe mit einer Wechselspannung, wobei ein Ausgangsanchluß (13) des Brückengleichrichters (1) sowie ein Eingangs- und ein Ausgangsanschluß des Wechselrichters (2) mit einem schaltungsinternen Bezugspotential-Anschluß (6) verbunden sind, **dadurch gekennzeichnet,**
**daß** der interne Bezugspotential-Anschluß (6) mit dem Phasenanschluß (L) und/oder dem Null-Leiteranschluß (N) oder mit einem und/oder beiden Eingangsanschlüssen (10,12) des Brückengleichrichters (1) wechselstrommäßig verbunden ist.

3. Elektronisches Vorschaltgerät nach Anspruch 1 oder 2,
**dadurch gekennzeichnet,**
**daß** die wechselstrommäßige Verbindung durch einen Kondensator (C7) gebildet ist.

4. Elektronisches Vorschaltgerät für eine Gasentladungslampe (3), bestehend aus einem an das Wechselspannungsnetz auzuschließenden Brückengleichrichter (1) und einem diesem nachgeschalteten Wechselrichter (2) zum Versorgen der Lampe mit einer Wechselspannung, wobei ein Ausgangsanchluß (13) des Brückengleichrichters (1) sowie ein Eingangs- und ein Ausgangsanschluß des Wechselrichters (2) mit einem schaltungsinternen Bezugspotential-Anschluß (6) verbunden sind,
**dadurch gekennzeichnet,**
**daß** die zur Lampe (3) führenden Leitungen (15-18) Abschirmungen (15,16,17,18) aufweisen, die mit dem schaltungsinternen Bezugspotential-Anschluß (6) verbunden sind.

## Claims

1. Electronic fluorescent lamp ballast for a gas discharge lamp (3), comprising a bridge rectifier (1) which is to be connected to the ac voltage network and a dc-ac converter (2) to be connected at the outlet side of this rectifier in order to supply the lamp with an ac voltage, in which an output connection (14) on the bridge rectifier (1) together with an input and an output connection on the dc-ac converter (2) are connected to a reference potential connection (6) within the circuit,
**characterized in that**
the reference potential connection(6) inside the circuit is connected in alternating current form to the protective earth (S) of the alternating current network.

2. Electronic fluorescent lamp ballast for a gas discharge lamp (3), comprising a bridge rectifier (1) which is to be connected to the ac voltage network and a dc-ac converter (2) which is connected at the outlet side of this rectifier in order to supply the lamp with an ac voltage, in which an output connection (13) on the bridge rectifier (1) together with an input and an output connection on the dc-ac converter (2) are connected to a reference potential connection (6) within the circuit,
**characterized in that**
the internal reference potential connection (6) is connected in alternating current form to the phase connection (L) and/or the neutral conductor connection (N) or to one and/or both input connections (10, 12) on the bridge rectifier (1).

3. Electronic fluorescent lamp ballast according to Claim 1 or 2,
**characterized in that**
the alternating current-like connection takes the form of a capacitor (C7).

4. Electronic fluorescent lamp ballast for a gas discharge lamp (3), comprising a bridge rectifier (1) which is to be connected to the ac voltage network and a dc-ac converter (2) which is connected at the outlet side of this rectifier in order to supply the lamp with an ac voltage, in which an output connection (13) on the bridge rectifier (1) together with an input and an output connection on the dc-ac converter (2) are connected to a reference potential connection (6) within the circuit,
**characterized in that**
the leads (15-18) going to the lamp (3) have screens (15, 16, 17, 18) which are connected to the reference potential connection (6) which is inside the circuit.

## Revendications

1. Ballast électronique destiné à une lampe à décharge (3) comprenant un redresseur (1) en pont connecté au réseau alternatif et un onduleur (2) monté derrière celui-ci pour alimenter la lampe avec une tension alternative, une borne de sortie (14) du redresseur (1) en pont ainsi qu'une borne d'entrée et une borne de sortie de l'onduleur (2) étant reliées à une borne (6) interne de potentiel de référence, **caractérisé par le fait que** la borne (6) interne de potentiel de référence est connectée côté courant alternatif à la terre (S) du réseau à courant alternatif.

2. Ballast électronique destiné à une lampe à décharge (3) comprenant un redresseur (1) en pont connecté au réseau alternatif et un onduleur (2) monté derrière celui-ci pour alimenter la lampe avec une tension alternative, une borne de sortie (13) du redresseur (1) en pont ainsi qu'une borne d'entrée et une borne de sortie de l'onduleur (2) étant reliées à une borne (6) interne de potentiel de référence, **caractérisé par le fait que** la borne (6) interne de potentiel de référence est connectée côté courant alternatif à la borne de phase (L) et/ou à la borne de neutre (N) ou à l'une et/ou aux deux bornes d'entrée (10, 12) du redresseur (1) en pont.

3. Ballast électronique selon la revendication 1 ou 2, **caractérisé par le fait que** la liaison côté courant alternatif est formée par un condensateur (C7).

4. Ballast électronique destiné à une lampe à décharge (3) comprenant un redresseur (1) en pont connecté au réseau alternatif et un onduleur (2) monté derrière celui-ci pour alimenter la lampe avec une tension alternative, une borne de sortie (13) du redresseur (1) en pont ainsi qu'une borne d'entrée et une borne de sortie de l'onduleur (2) étant reliées à une borne (6) interne de potentiel de référence, **caractérisé par le fait que** les lignes (15-18) qui mènent à la lampe (3) sont pourvues de blindages (15, 16, 17, 18) qui sont connectés à la borne (6) interne de potentiel de référence.
